# EUROPEAN PATENT APPLICATION

(11) **EP 2 531 011 A2**
(43) Date of publication of application: **05.12.2012**
(21) Application number: 12160572.9
(22) Date of filing: 21.03.2012
(51) Int. Cl.: H05K 7/14

(54) **Electronic device**

(30) Priority: 30.05.2011 JP 2011120812
(71) Applicant: Fujitsu Limited, Kawasaki-shi, Kanagawa 211-8588 (JP)
(72) Inventor: Tachibana, Masanori, Kanagawa, 211-8588 (JP); Shimasaki, Akira, Kanagawa, 211-8588 (JP)
(74) Representative: HOFFMANN EITLE

(57) **Abstract**

An electronic device including five input-end bus bars (11-15) supplied with three-phase alternating-current power, and three units (P, Q, R) connected to the five input-end bus bars and supplied with single-phase alternating-current power, and the three units include a first unit (P) including a first terminal (P1) and a second terminal (P2), a second unit (Q) including a third terminal (Q1) and a fourth terminal (Q2), and a third unit (R) including a fifth terminal (R1) and a sixth terminal (R2), and the five input-end bus bars include a first input-end bus bar (11) connected to the first terminal and the third terminal, a second input-end bus bar (12) connected to the fifth terminal, a third input-end bus bar (13) connected to the second terminal, a fourth input-end bus bar (14) connected to the fourth terminal, and a fifth input-end bus bar (15) connected to the sixth terminal.

## Description

### FIELD

The embodiments discussed herein are related to an electronic device including bus bars.

### BACKGROUND

In recent years, an increasing number of devices with higher-density packaging have been used as server devices installed in data centers and the like in order to make an effective use of space.

When the server devices are sold overseas, the power source voltage used in the devices is adaptable to a three-phase four-wire system, which is commonly used in China and Europe, in addition to a three-phase three-wire system, which is used in Japan and North America.

When the three-phase AC power is converted into a single-phase AC power by using bus bars in the device casing, since the connection structure of the bus bars are different depending on the power distribution system, the device may have some bus bar structures that are suitable to each of the systems.

It should be noted that a bus bar is, for example, a long plate or a rod-shaped metal member used as a power supply line.

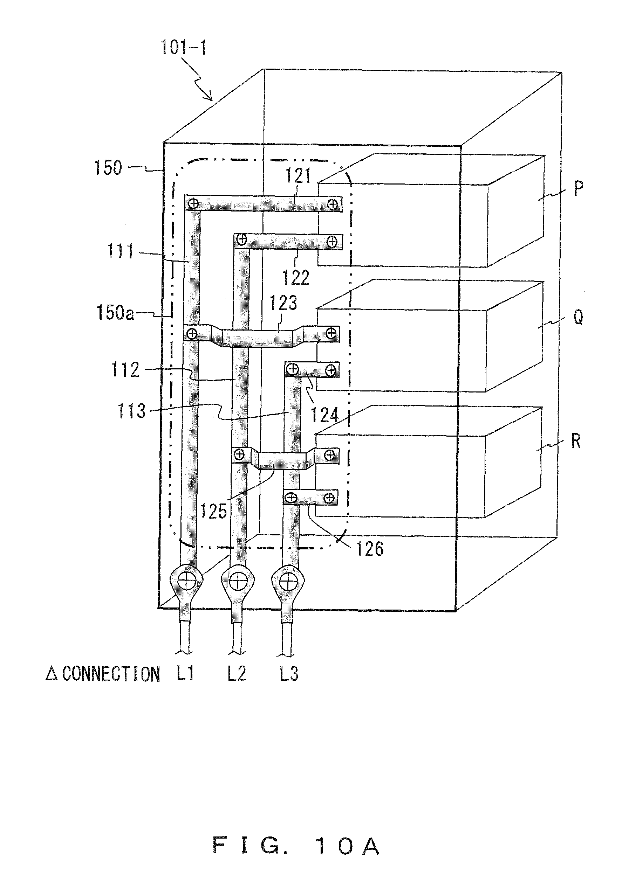

An electronic device 101-1 (three-phase three-wire: Δ connection) illustrated in FIG. 10A has three input-end bus bars 111, 112, and 113, each of which is respectively connected to each of the power supply lines L1, L2, and L3 to which three-phase three-wire power is input, for supplying single-phase AC power to three units P, Q, and R.

The input-end bus bar 111 connected to the power supply line L1 is connected to the supply-end bus bar 121 connected to the unit P and the supply-end bus bar 123 connected to the unit Q.

The input-end bus bar 112 connected to the power supply line L2 is connected to the supply-end bus bar 122 connected to the unit P and the supply-end bus bar 125 connected to the unit R.

The input-end bus bar 113 connected to the power supply line

L3 is connected to the supply-end bus bar 124 connected to the unit Q and the supply-end bus bar 126 connected to the unit R.

It should be noted that each of the power supply lines L1, L2, and L3, bus bars 111 to 126, and units P, Q, and R are connected to one another by, for example, bolts and screws.

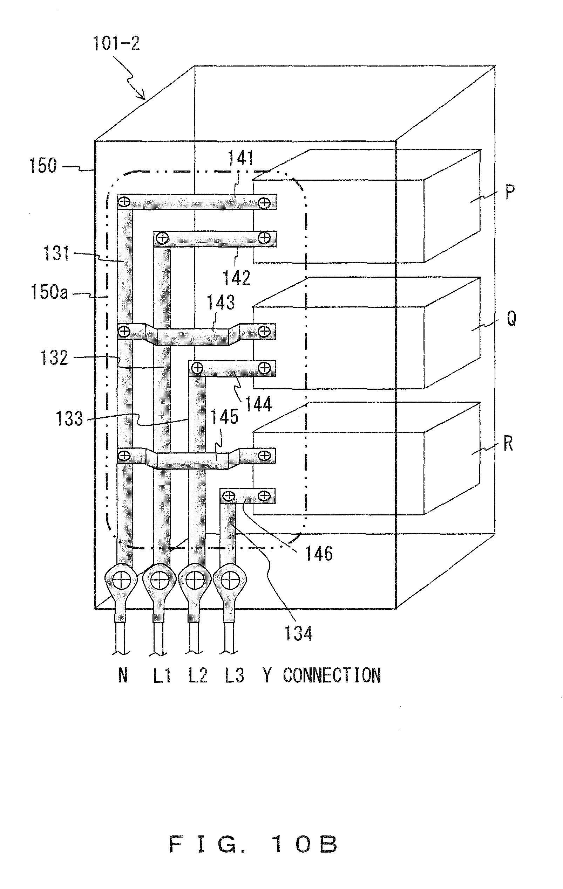

An electronic device 101-2 (three-phase four-wire: Y connection) illustrated in FIG. 10B has four input-end bus bars 131, 132, 133, and 134, each of which is respectively connected to each of the power supply lines N, L1, L2, and L3 to which three-phase four-wire power is input, for supplying single-phase AC power to three units P, Q, and R.

The input-end bus bar 131 connected to the neutral line N is connected to a supply-end bus bar 141 connected to the unit P, a supply-end bus bar 143 connected to the unit Q, and a supply-end bus bar 145 connected to the unit R.

The input-end bus bar 132 connected to the power supply line L1 is connected to a supply-end bus bar 142 connected to the unit P.

The input-end bus bar 133 connected to the power supply line L2 is connected to a supply-end bus bar 144 connected to the unit Q.

The input-end bus bar 134 connected to the power supply line L3 is connected to a supply-end bus bar 146 connected to the unit R.
Patent Document 1: Japanese Laid-open Patent Publication No. 11-234815
Patent Document 2: Japanese Laid-open Patent Publication No. 2001-216032

### SUMMARY

It is an object in one aspect of the embodiment to provide an electronic device that can save space in the switching from the three-phase AC power to the single-phase AC power by using bus bars and it is also possible to easily respond to the difference in power distribution systems.

An electronic device disclosed in the present specification includes five input-end bus bars supplied with three-phase alternating-current power and three units connected to the five input-end bus bars and supplied with single-phase alternating-current power. The three units include a first unit including a first terminal and a second terminal, a second unit including a third terminal and a fourth terminal, 1 and a third unit including a fifth terminal and a sixth terminal. The five input-end bus bars include a first input-end bus bar connected to the first terminal and the third terminal, a second input-end bus bar connected to the fifth terminal, a third input-end bus bar connected to the second terminal, a fourth input-end bus bar connected to the fourth terminal, and a fifth input-end bus bar connected to the sixth terminal.

### BRIEF DESCRIPTION OF DRAWINGS

FIG. 1 is an outline structural drawing illustrating the structure of the bus bar of the first embodiment;
FIG. 2A is an outline structural drawing illustrating an electronic device (type of distribution system: three-phase three-wire system) according to the first embodiment;
FIG. 2B is an outline structural drawing illustrating an electronic device (type of distribution system: three-phase four-wire system) according to the first embodiment;
FIG. 3 is an outline structural drawing illustrating a structure of the bus bars in the second embodiment;
FIG. 4 is a diagram explaining the coupling of the bus bars in the second embodiment;
FIG. 5 is an outline structural drawing illustrating a structure of the bus bars in the third embodiment;
FIG. 6A is an outline structural drawing illustrating an electronic device (type of distribution system: three-phase three-wire system) according to the third embodiment;
FIG. 6B is an outline structural drawing illustrating an electronic device (type of distribution system: three-phase four-wire system) according to the third embodiment;
FIG. 7A is an outline structural drawing illustrating an electronic device (type of distribution system: three-phase three-wire system) according to the fourth embodiment;
FIG. 7B is an outline structural drawing illustrating an electronic device (type of distribution system: three-phase four-wire system) according to the fourth embodiment;
FIG. 8 is an outline structural drawing illustrating a structure of the bus bars in the fifth embodiment;
FIG. 9A is an outline structural drawing illustrating an electronic device (type of distribution system: three-phase three-wire system) according to the fifth embodiment;
FIG. 9B is an outline structural drawing illustrating an electronic device (type of distribution system: three-phase four-wire system) according to the fifth embodiment.
FIG. 10A is an outline structural drawing illustrating an electronic device (type of distribution system: three-phase three-wire system) according to a related art; and
FIG. 10B is an outline structural drawing illustrating an electronic device (type of distribution system: three-phase four-wire system) according to a related art.

### DESCRIPTION OF EMBODIMENTS

When a distribution system needs to be changed within the same device casing due to relocation of the device after shipping of the device or changes in the specification before shipping of the device, the entirety of the bus bar portions need to be replaced.

The bus bar portions have to supply power to unit components in the above-described server devices with high-density packaging and other electrical devices and are often located in a part of the device where tools cannot easily reach (portion 150a indicated by a two-dot chain line in the casing 150 in FIG. 10A and FIG. 10B). Replacement of the bus bar portion involves time and effort because tools cannot reach the bus bar portions for the purpose of replacing them without removing other components such as unit components.

In order to save this effort, in a case in which both of the structures can be provided in the device in advance and one of the structures can be used in accordance with the distribution system or switching between the structures via a switch can performed, a larger space is needed for an increased number of bus bars and additional structural component for the switch portion, and high-density packaging cannot be realized.

In the following description, an electronic device according to the embodiments is explained with reference to the drawings.

### <First Embodiment>

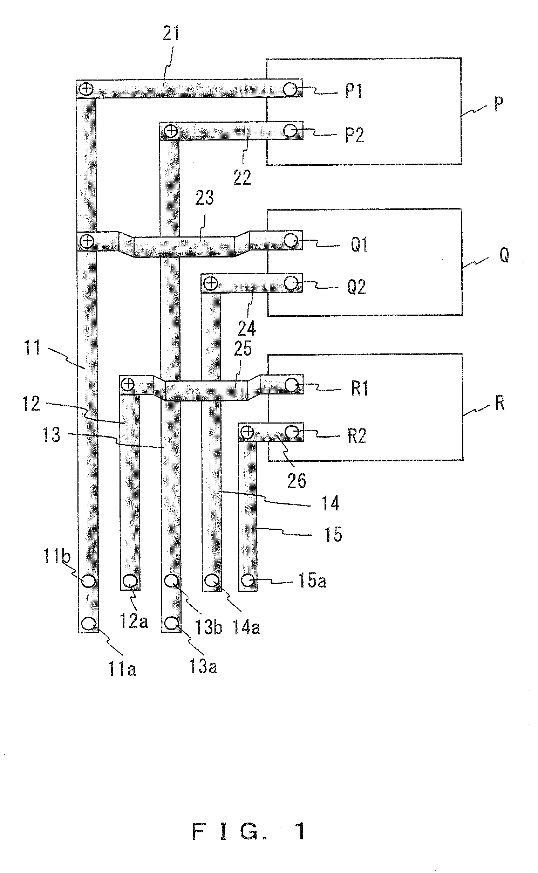

FIG. 1 is an outline structural drawing illustrating the structure of the bus bar of the first embodiment.

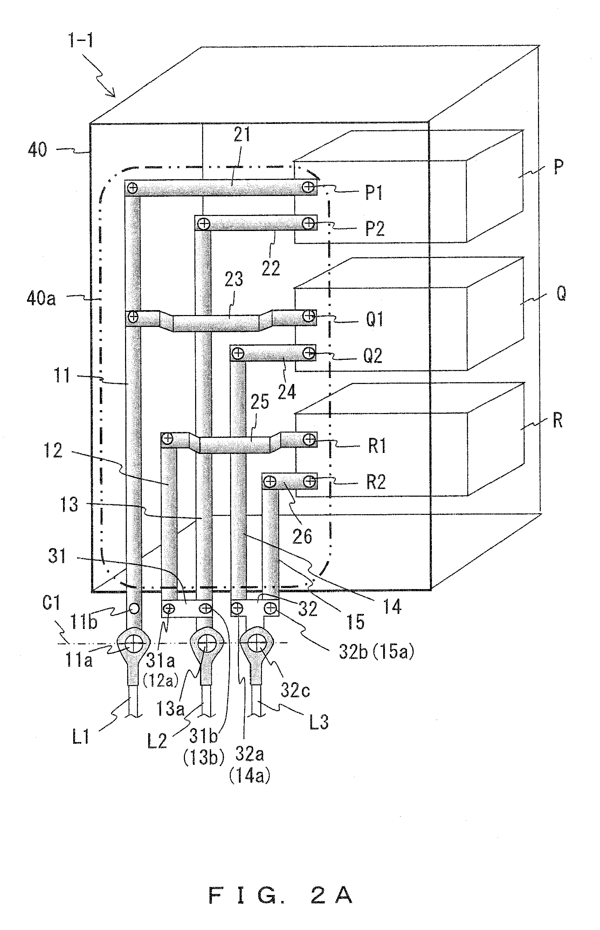

FIG. 2A is an outline structural drawing illustrating an electronic device 1-1 (type of distribution system: three-phase three-wire system) according to the first embodiment.

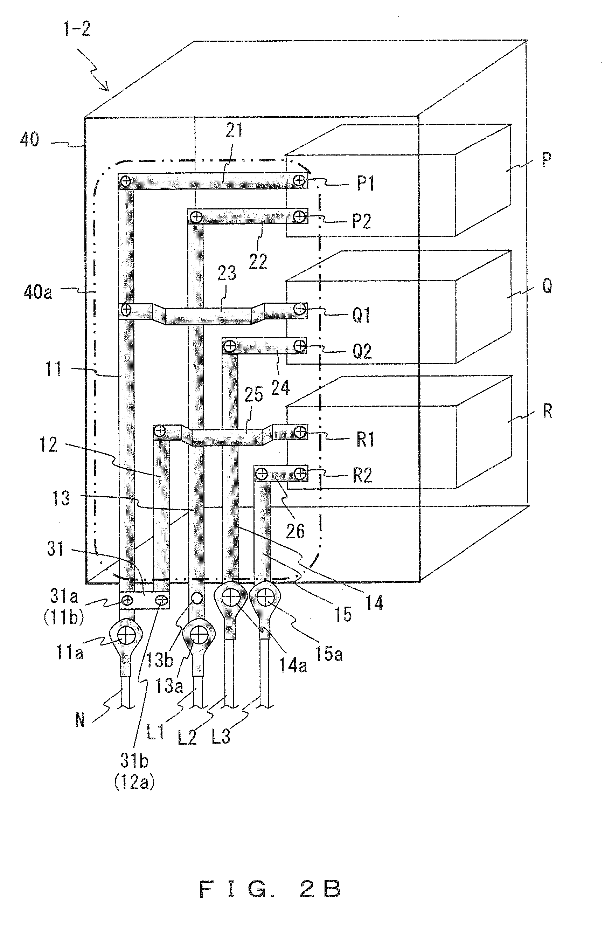

FIG. 2B is an outline structural drawing illustrating an electronic device 1-2 (type of distribution system: three-phase four-wire system) according to the first embodiment.

As illustrated in FIG. 1 to FIG. 2B, an electronic device 1, which for example is a server device, is provided with first to fifth input-end bus bars 11, 12, 13, 14 , and 15, each of which is supplied with three-phase AC power, and three units P, Q, and R connected to these five bus bars and supplied with single-phase AC power.

The first unit P has the first terminal P1 and the second terminal P2.

The second unit Q has the first terminal Ql and the fourth terminal Q2.

The third unit R has the fifth terminal R1 and the sixth terminal R2.

The first to the sixth supply-end bus bars 21 to 26, each of which is arranged to make a right angle with respect to the first to the fifth input-end bus bars 11 to 15, are connected respectively to the first to the sixth terminals P1 to R2. It should be noted that the bus bars 11 to 15 and 21 to 26 are formed by, for example, proper processing such as bending a copper plate with a thickness of 2 to 4 mm (several mm). However, other thicknesses or other materials can also be used.

The first input-end bus bar 11 is connected to the first supply-end bus bar 21 and the third supply-end bus bar 23 and is thereby connected to the first terminal P1 and the third terminal Q1.

The second input-end bus bar 12 is connected to the fifth supply-end bus bar 25 and is thereby connected to the fifth terminal R1.

The third input-end bus bar 13 is connected to the second supply-end bus bar 22 and is thereby connected to the second terminal P2.

The fourth input-end bus bar 14 is connected to the fourth supply-end bus bar 24 and is thereby connected to the fourth terminal Q2.

The fifth input-end bus bar 15 is connected to the sixth supply-end bus bar 26 and is thereby connected to the sixth terminal R2.

It should be noted that the first to the fifth input-end bus bars 11 to 15 and the first to the sixth supply-end bus bars 21 to 26 can be integrated rather than separated. In addition, the first to the fifth input-end bus bars 11 to 15 and the first to the sixth supply-end bus bars 21 to 26 can optionally curve so as not to interfere with each other. For example, in the present embodiment, the third supply-end bus bar 23 curves so as to avoid interference with the third input-end bus bar 13, and the fifth supply-end bus bar 25 curves so as to avoid interference with the third input-end bus bar 13 and the fourth input-end bus bar 14.

The first input-end bus bar 11 and the third input-end bus bar 13 protrude further toward the input end than the second, fourth, and fifth input-end bus bars 12, 14, and 15.

Connector parts 11a to 15a, which are processed by tapping, are formed at the tips of the first to the fifth input-end bus bar 11 to 15 at the input end.

The first input-end bus bar 11 and the third input-end bus bar 13 have the connector parts 11b and 13b formed on the same line as the connector parts 12a, 14a and 15a of the second, fourth, and fifth input-end bus bars 12, 14, and 15.

As illustrated in FIG. 2A, in the electronic device 1-1, when the power is supplied through the three-phase three-wire system, the second input-end bus bar 12 and the third input-end bus bar 13 are coupled with each other by the first coupling unit 31, which is for example an I-shaped (rectangular) bus bar.

The fourth input-end bus bar 14 and the fifth input-end bus bar 15 are coupled with each other by the second coupling unit 32, which is for example a T-shaped bus bar.

The first coupling unit 31 is, for example, bolted on the connector part 12a of the second input-end bus bar 12 at a connector part 31a at an end that is processed to form a clearance hole, for example. In addition, the first coupling unit 31 is, for example, bolted on the connector part 13b of the third input-end bus bar 13 at another end that is processed to form a clearance hole, for example.

The second coupling unit 32 is, for example, bolted on the connector part 14a of the fourth input-end bus bar 14 at an upper left connector part 32a processed to form a clearance hole, for example. In addition, the second coupling unit 31 is, for example, bolted on the connector part 15a of the fifth input-end bus bar 15 at an upper right connector part 31b that is processed to form a clearance hole, for example.

A power supply line L1 is connected to the connector part 11a of the first input-end bus bar 11.

A power supply line L2 is connected to the connector part 13a of the third input-end bus bar 13.

A power supply line L3 is connected to the connector part 32c processed by, for example, tapping at the low end of the second coupling unit 32.

It should be noted that the second coupling unit 32 functions as an extension unit to extend the fourth input-end bus bar 14 and the fifth input-end bus bar 15. For that reason, the connection locations of each of the power supply lines L1 to L3 with the connector parts 11a, 13a, and 32c of the first input-end bus bar 11, the third input-end bus bar 13, and the second coupling unit 32, respectively, are located on the same line C1.

As illustrated in FIG. 2B, in the electronic device 1-2, when the power is supplied through the three-phase four-wire system, the first input-end bus bar 11 and the second input-end bus bar 12 are coupled with one another by the first coupling unit 31. Apart from these, the input-end bus bars are not coupled with one another.

A neutral line N is connected to the connector part 11a of the first input-end bus bar 11.

The power supply line L1 is connected to the connector part 13a of the third input-end bus bar 13.

The power supply line L2 is connected to the connector part 14a of the fourth input-end bus bar 14.

The power supply line L3 is connected to the connector part 15a of the fifth input-end bus bar 15.

It should be noted that the connection locations of the first coupling unit 31 illustrated in FIG. 2A and FIG. 2B, the second coupling unit 32 illustrated in FIG. 2A, the power supply lines L1 to L3, and the neutral line N are located outside of the device internal portion 40a (e.g., in a portion that tools cannot easily reach) indicated by a two-dot chain line in the casing 40 of the electronic device 1.

In the first embodiment explained above, the electronic device 1 includes five input-end bus bars 11 to 15 supplied with three-phase AC power and three units P, Q, and R connected to the five input-end bus bars 11 to 15 and supplied with a single-phase AC power.

For that reason, it is possible to switch between the AC source of the three-phase three-wire system and the AC source of the three-phase four-wire system with a simple configuration. In addition, it is possible to switch the systems with easy operations such as replacing coupling units 31 and 32.

Thus, according to the present embodiment, it is possible to save space in the switching from the three-phase AC power to the single-phase AC power by using bus bars and it is also possible to easily respond to the difference in power distribution systems.

The present embodiment can realize high-density packaging of the bus bars, and it is possible to easily switch between the three-phase three-wire system and the three-phase four-wire system at the time of relocation of devices after shipping the devices or at the time of changes in the specification before shipping of the devices, resulting in a reduction of man-hours.

Since the replacement only requires work to be performed around the outside of the casing 40 where tools can easily reach (outside of the device internal portion 40a where tools do not easily reach), the working area of the workers can be limited so that mistakes in the work can be reduced and the mounting and dismounting of weighty unit components in the casing so that tools for the work can reach the components can be avoided, which is effective in regards to safety.

Moreover, since there is current flow in the bus bar portions, a continuity check should be performed after the replacement. However, the present embodiment only changes the power input ends near the outside of the casing 40, and the continuity check up to the units P, Q, and R after the replacement from the three-phase AC power to the single-phase AC power is no longer a requirement, and therefore the number of items to be checked is reduced.

In the present embodiment, the first to the fifth input-end bus bars 11 to 15 are connected to the first to the sixth terminals P1 to R2 through the first to the sixth supply-end bus bars 21 to 26. As a result, the configuration can be made simple.

Furthermore, in the present embodiment, the first input-end bus bar 11 and the second input-end bus bar 12 in FIG. 2B can be coupled to each other by a coupling unit 31 that is the same as the coupling unit 31 for coupling the second input-end bus bar 12 and the third input-end bus bar 13 in FIG. 2A. For that reason, the configuration can be made simple.

In the present embodiment, the connection locations of the connector parts 11a, 13a, and 32c connecting each of the power supply lines L1 to L3 to the first input-end bus bar 11, the third input-end bus bar 13, and the second coupling unit 32, respectively, are located on the same line C1. Accordingly, workability can be enhanced.

### <Second Embodiment>

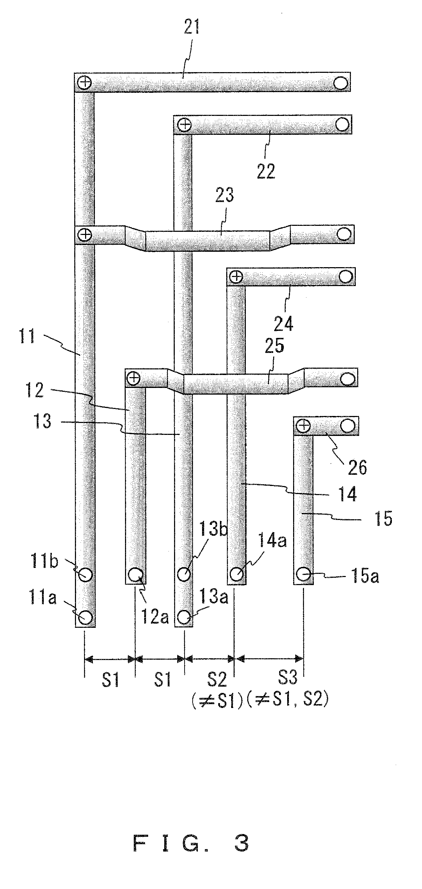

FIG. 3 is an outline structural drawing illustrating a structure of the bus bars in the second embodiment.

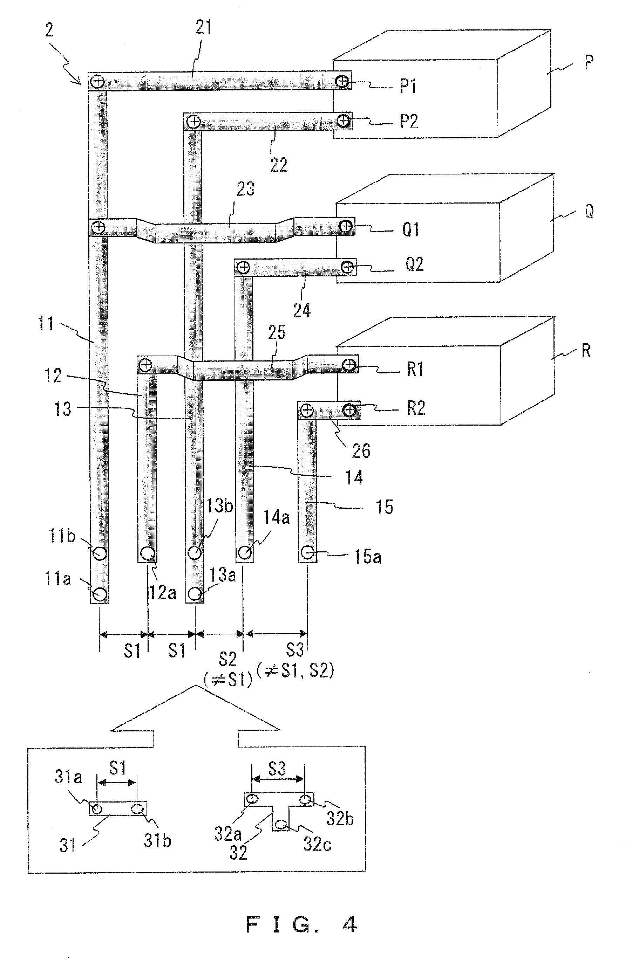

FIG. 4 is a diagram explaining the coupling of the bus bars in the second embodiment.

The present embodiment is different from the above-described first embodiment in the intervals between the input-end bus bars 11 to 15. Since the rest of the points are the same as those in the first embodiment, detailed explanations of the same portions are omitted.

As illustrated in FIG. 3, at least one of an interval S1 between the first input-end bus bar 11 and the second input-end bus bar 12 and an interval S1 between the second input-end bus bar 12 and the third input-end bus bar 13, an interval S2 between the third input-end bus bar 13 and the fourth input-end bus bar 14, and an interval S3 between the fourth input-end bus bar 14 and the fifth input-end bus bar 15 are different from one another.

In the present embodiment, the interval S1 between the first input-end bus bar 11 and the second input-end bus bar 12 matches the interval S1 between the second input-end bus bar 12 and the third input-end bus bar 13.

As illustrated in FIG. 4, the first coupling unit 31 of an electronic device 2 has an interval S1 between the connector parts 31 a and 31b. For that reason, at the time of switching between the three-phase three-wire system illustrated in FIG. 2A and the three-phase four-wire system illustrated in FIG. 2B in the above-described first embodiment, the first coupling unit 31 is arranged only between the first input-end bus bar 11 and the second input-end bus bar 12 (in the three-phase three-wire system) and between the second input-end bus bar 12 and the third input-end bus bar 13 (in the three-phase four-wire system).

It should be noted that when different coupling units are used to connect between the first input-end bus bar 11 and the second input-end bus bar 12 (in the three-phase three-wire system) and to connect between the second input-end bus bar 12 and the third input-end bus bar 13 (in the three-phase four-wire system), the intervals of these bus bars should also be different.

The second coupling unit 32 has an interval S3 between the connector part 32a and the connector part 32b. For that reason, the second coupling unit 32 is arranged only between the fourth input-end bus bar 14 and the fifth input-end bus bar 15 in the three-phase three-wire system illustrated in FIG. 2A in the above-described first embodiment.

The same advantage as the advantage of the above-described first embodiment can be obtained from the above-described second embodiment. More specifically, the advantage is that the embodiment realizes space-saving and can easily respond to the difference in power distribution systems.

In the present embodiment, at least one of the interval S1 between the first input-end bus bar 11 and the second input-end bus bar 12 and the interval S1 between the second input-end bus bar 12 and the third input-end bus bar 13, the interval S2 between the third input-end bus bar 13 and the fourth input-end bus bar 14, and the interval S3 between the fourth input-end bus bar 14 and the fifth input-end bus bar 15 are different from one another. In the present embodiment, the interval S1 between the first input-end bus bar 11 and the second input-end bus bar 12 matches the interval S1 between the second input-end bus bar 12 and the third input-end bus bar 13. Accordingly, the present embodiment can prevent mistakes in the arrangement of the coupling unit and therefore enables easier response to the differences in the power distribution systems.

### <Third Embodiment>

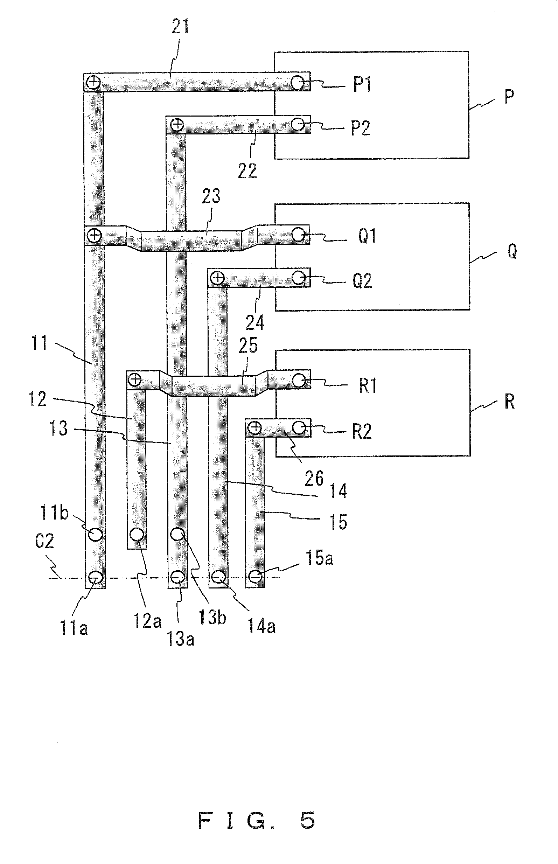

FIG. 5 is an outline structural drawing illustrating a structure of the bus bars in the third embodiment.

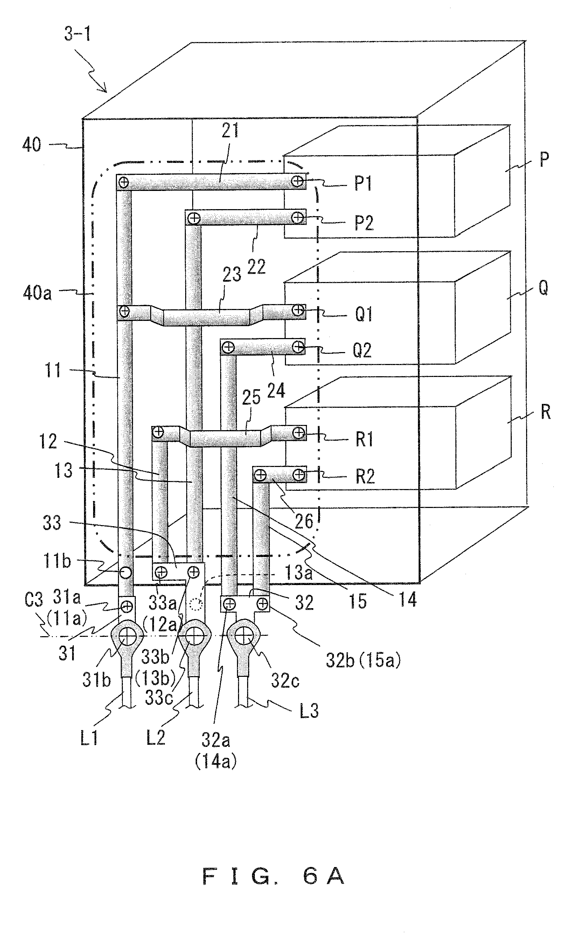

FIG. 6A is an outline structural drawing illustrating an electronic device 3-1 (type of distribution system: three-phase three-wire system) according to the third embodiment.

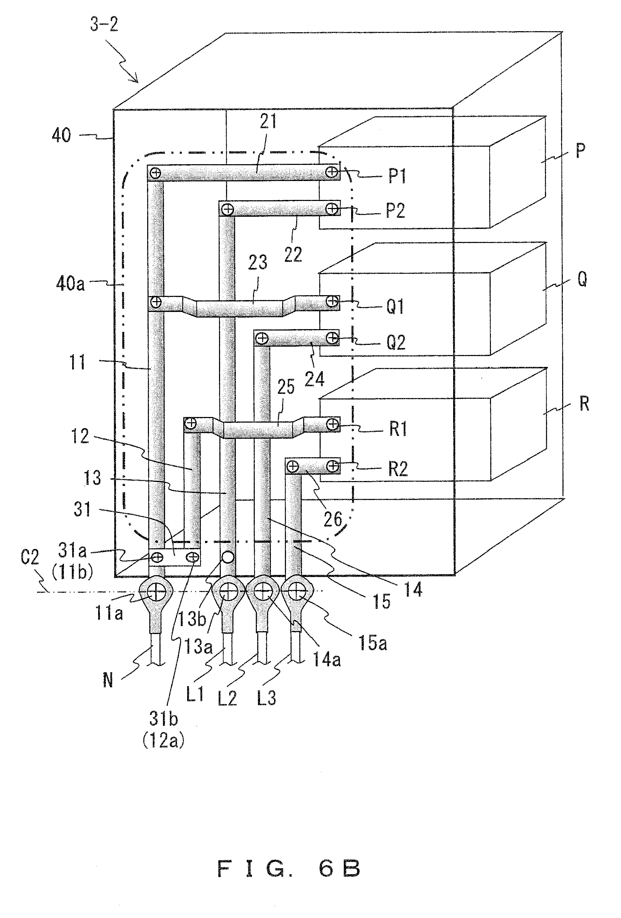

FIG. 6B is an outline structural drawing illustrating an electronic device 3-2 (type of distribution system: three-phase four-wire system) according to the third embodiment.

The present embodiment is different from the above-described first embodiment in the length of the input-end bus bars 11 to 15 and the arrangement of the coupling units 31 to 33. Since the rest of the points are the same as those in the first embodiment, detailed explanations of the same portions are omitted.

The first, third, fourth, and fifth input-end bus bars 11, 13, 14, and 15 protrude further toward the input end than the second input-end bus bar 12.

The connector parts 11a to 15a, which are processed by tapping, are formed at the tips of the first to the fifth input-end bus bar 11 to 15 at the input end. The connector parts 11a, 13a, 14a, and 15a of the first, third, fourth, and fifth input-end bus bars 11, 13, 14, and 15 are located on the same line C2.

The first input-end bus bar 11 and the third input-end bus bar 13 also have connector parts 11b and 13b, respectively, formed on the same line as the connector part 12a of the second input-end bus bar 12.

As illustrated in FIG. 6A, in the electronic device 3-1, when the power is supplied through the three-phase three-wire system, the second input-end bus bar 12 and the third input-end bus bar 13 are coupled with each other by the third coupling unit 33, which is for example an L-shaped bus bar.

The fourth input-end bus bar 14 and the fifth input-end bus bar 15 are coupled with each other by the second coupling unit 32, which is for example a T-shaped bus bar.

The first input-end bus bar 11 has the above-described first coupling unit 31, which is for example an I-shaped bus bar connected to the connector part 11a and is connected to the power supply line L1 at the tip.

The third coupling unit 33 is, for example, bolted on the connector part 12a of the second input-end bus bar 12 at the upper left connector part 33a that is processed to form a clearance hole, for example. In addition, the third coupling unit 33 is, for example, fixed by a bolt and a nut on the connector part 13b of the third input-end bus bar 13 at the upper right connector part 33b that is processed to form a clearance hole, for example.

Furthermore, the third coupling unit 33 is connected to the power supply line L2 in the lower right connector part 33c that is processed by tapping, for example, at a location closer to the tip than the connector part 13a of the input-end bus bar 13.

The second coupling unit 32 that couples the fourth input-end bus bar 14 and the fifth input-end bus bar 15 is the same as that of the above-described first embodiment (FIG. 2A).

The above-described first to third coupling units 31 to 33 function as an extension unit coupling between at least one of the first input-end bus bar 11, a coupling body of the second input-end bus bar 12 and the third input-end bus bar 13, and a coupling body of the fourth input-end bus bar 14 and the fifth input-end bus bar 15 (these three are all in the present embodiment) and the power supply lines L1 to L3 of the three-phase three-wire system.

With the configuration described above, the power supply lines L1 to L3 are connected to the coupling units 31, 33, and 32, respectively, on the same line C3.

As illustrated in FIG. 6B, in the electronic device 3-2, when the power is distributed through the three-phase four-wire system, similarly to the above-described first embodiment (FIG. 2B), the first input-end bus bar 11 and the second input-end bus bar 12 are coupled with one another by the first coupling unit 31, but the input-end bus bars are not coupled with one another in the other places.

The neutral line N and the power supply lines L1 to L3 are connected to the first, third, fourth and fifth input-end bus bars 11, 13, 14, and 15, respectively, on the same line C2 at the respective connector parts 11a, 13a, 14a, and 15a, located at the tips of these bus bars.

According to the above-explained third embodiment, it is possible to obtain the same advantage as that of the above-described first embodiment. More specifically, it is possible for the embodiment to realize space-saving and to be able to easily respond to the difference in power distribution systems.

Moreover, in the present embodiment, the positions of the power supply lines L1 to L3 are located on the same line C3 at the time of using the three-phase three-wire system and the positions of the neutral line N and the power supply lines L1 to L3 are located on the same line C2 at the time of using the three-phase four-wire system. For that reason, workers can work without changing the height in either system and the workability is enhanced. In addition, because the heights (locations) of the lines are different between the three-phase three-wire system and the three-phase four-wire system (line C2 and line C3), the workers can easily respond to the difference in the power distribution systems.

### <Fourth Embodiment>

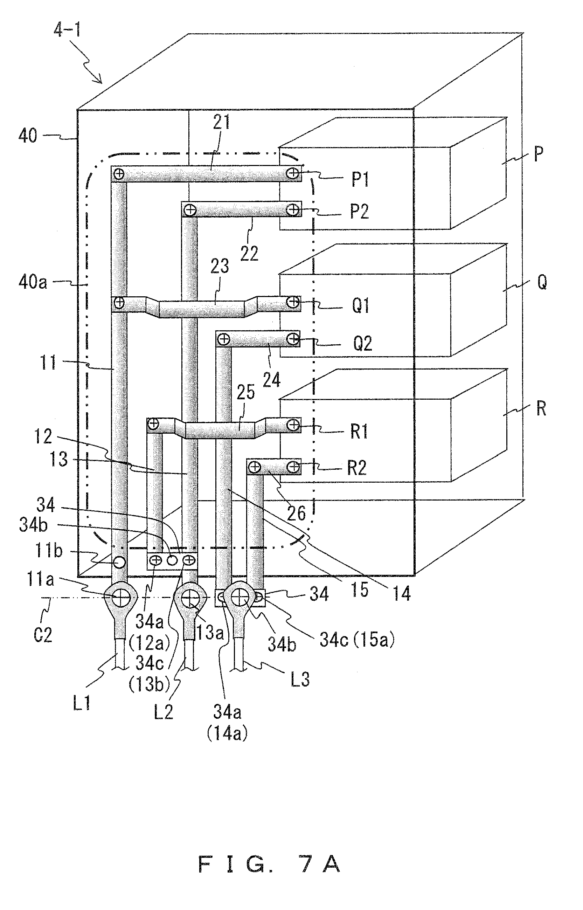

FIG. 7A is an outline structural drawing illustrating an electronic device 41-1 (type of distribution system: three-phase, three-wire system) according to the fourth embodiment.

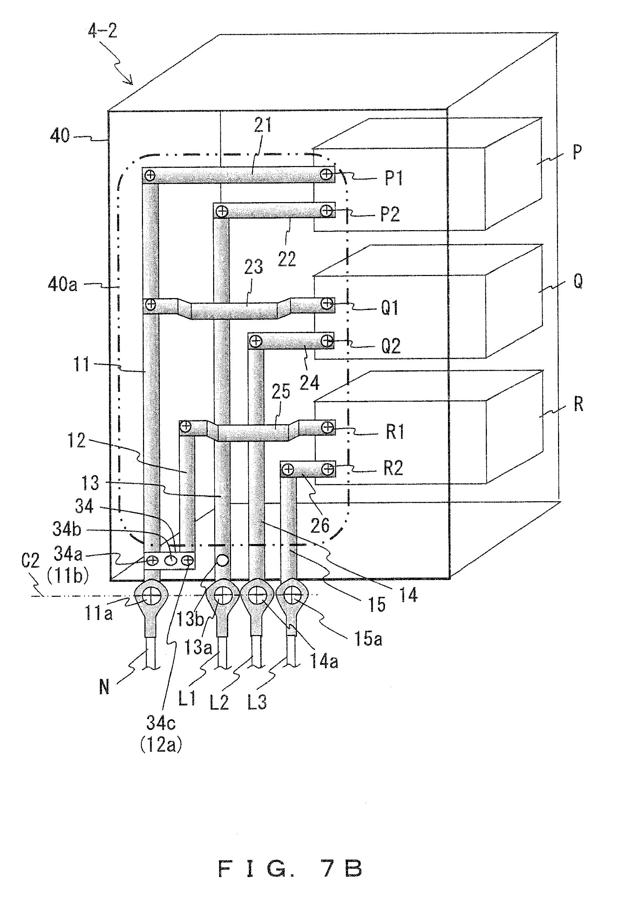

FIG. 7B is an outline structural drawing illustrating an electronic device 4-2 (type of distribution system: three-phase four-wire system) according to the fourth embodiment.

In the present embodiment, although the arrangement at the time of using the three-phase four-wire system (FIG. 7B) is the same as the arrangement of the third embodiment (FIG. 6B), the first input-end bus bar 11 and the second input-end bus bar 12 are coupled by the fourth coupling unit 34, which is described later.

On the other hand, as illustrated in FIG. 7A, in the electronic device 4-1, when the power is distributed through the three-phase three-wire system, the first coupling unit 31 is not arranged in the first input-end bus bar 11 but the power supply line L1 is connected to the connector part 11a, which is the same as the configuration in the first embodiment (FIG. 2A), so that the connecting locations of the power supply lines L1 to L3 are located on the line C2 in the same as location at the time of using the three-phase four-wire system.

Moreover, although the second input-end bus bar 12 and the third input-end bus bar 13 are coupled in the same manner as the bus bars are coupled in the first embodiment, in the present embodiment, the second input-end bus bar 12 and the third input-end bus bar 13 are coupled with one another by the fourth coupling unit 34, which is an 1-shaped (rectangular) bus bar, for example, in which three connector parts 34a, 34b, and 34c are formed in a row in a longitudinal direction.

The fourth input-end bus bar 14 and the fifth input-end bus bar 15 are coupled with one another by a coupling unit (fourth coupling unit 34) that has an identical shape as the shape of the fourth coupling unit 34 that couples the second input-end bus bar 12 and the third input-end bus bar 13. The connector part 34b in the center of the fourth coupling unit 34 is connected to the power supply line L3.

It should be noted that the connector parts 34a and 34c at both ends of the fourth coupling unit 34 are processed to form a clearance hole, for example, and the connector part 34b in the center is processed by tapping, for example.

According to the above-described fourth embodiment, it is possible to obtain the same advantage as that of the above-described first embodiment. More specifically, it is possible for the embodiment to realize space-saving and to be able to easily respond to the difference in power distribution systems.

In the present embodiment, both the positions of the power supply lines L1 to L3 at the time of using the three-phase three-wire system and the positions of the neutral line N and the power supply lines L1 to L3 at the time of using the three-phase four-wire system are located on the same line C2. For that reason, workers can work without changing the height in either system and the workability is enhanced.

In order for the electronic device 4 to realize higher-density packaging in a server device, as an example, if the connecting locations are different between the three-phase three-wire system and the three-phase four-wire system, a space is needed at the connecting portion at the power input end so that the same casing 40 can be used in both of the systems. However, in the present embodiment, regardless of whether the three-phase three-wire system or the three-phase four-wire system is used, the connecting location of the power supply lines L1 to L3 (and the neutral line N) can be aligned on the same line C2, which results in high-density packaging because less space is needed for the connecting portion at the power input end.

When the connecting location is aligned, connecting of terminals at the power input end can be performed with little change between the three-phase three-wire system and the three-phase four-wire system, resulting in improvement in workability. In addition, the length of the lines at the power input end can be unified.

Moreover, in the present embodiment, the fourth coupling unit 34 is arranged at different portions in the three-phase three-wire system and the three-phase four-wire system to achieve component commonality, which results in reduction in cost and improvement of parts control work efficiency.

Furthermore, in the present embodiment, two fourth coupling units 34 with an identical shape are used at the time of using the three-phase three-wire system, and therefore it is possible to achieve component commonality in this point.

### <Fifth Embodiment>

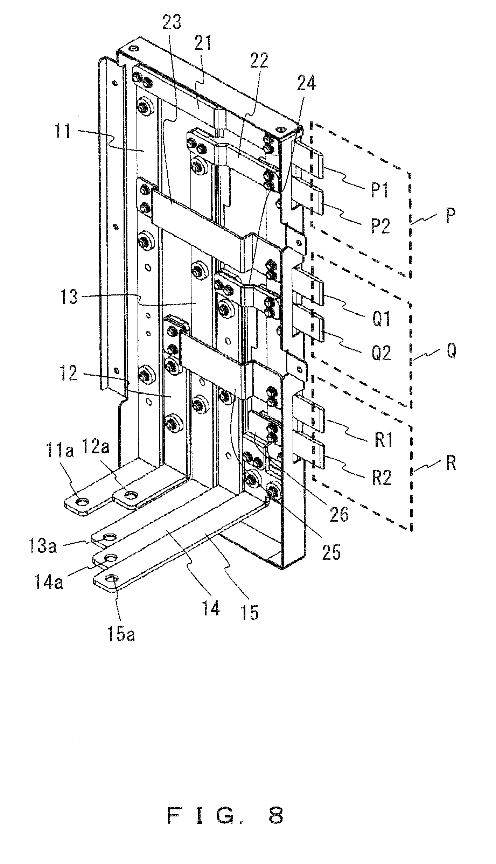

FIG. 8 is an outline structural drawing illustrating a structure of the bus bars in the fifth embodiment.

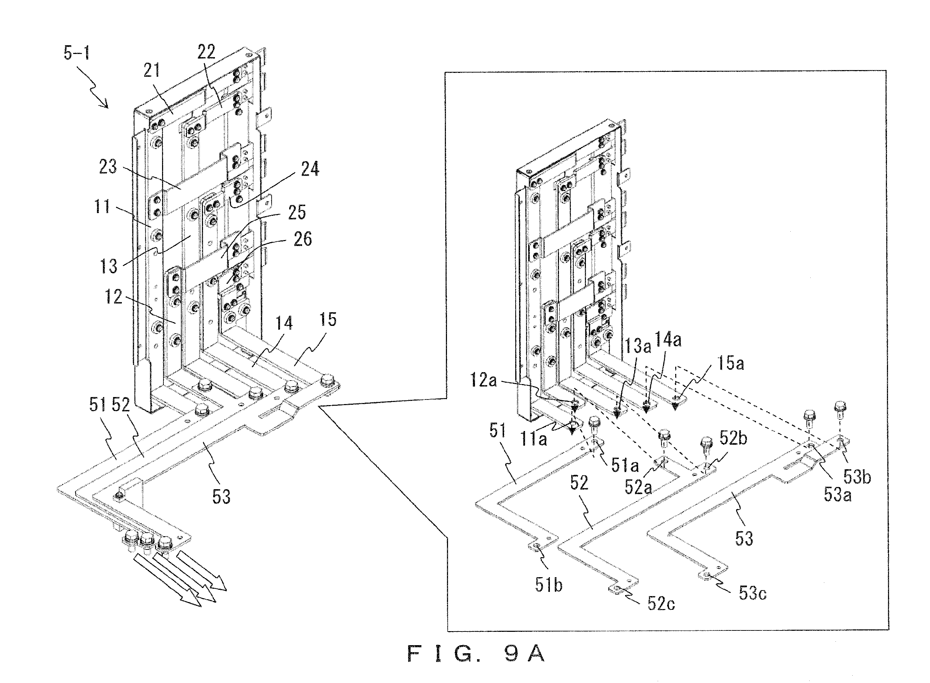

FIG. 9A is an outline structural drawing illustrating an electronic device 5-1 (type of distribution system: three-phase three-wire system) according to the fifth embodiment.

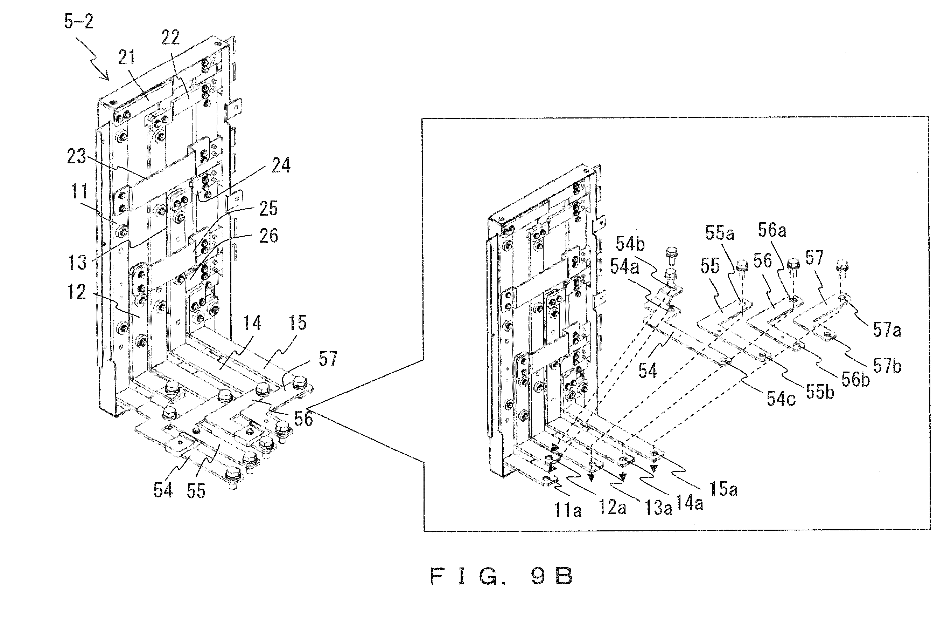

FIG. 9B is an outline structural drawing illustrating an electronic device 5-2 (type of distribution system: three-phase four-wire system) according to the fifth embodiment.

In the present embodiment, the basic structures of the first to fifth input-end bus bars 11 to 15 and the first to sixth supply-end bus bars 21 to 26 are the same as the structures in the above embodiments, and therefore detailed explanations are omitted.

As illustrated in FIG. 8, the first to fifth input-end bus bars 11 to 15 are bent at a 90-degree angle, for example. The connector parts 11a to 15a provided only at the tip of the first to fifth input-end bus bars 11 to 15 have self-locking nuts pressed into them so that the units can be fixed by bolts, for example.

As illustrated in FIG. 9A, in the electronic device 5-1, when the power is distributed through the three-phase three-wire system, the first extension bus bar 51 is connected to the connector part 11a of the first input-end bus bar 11 at a connector part 51a at one end of the first extension bus bar 51 and is also connected to the power supply line at another end 51b.

The second input-end bus bar 12 and the third input-end bus bar 13 are coupled by the second extension bus bar 52. This second extension bus bar 52 is coupled to the connector parts 12a and 13a of the second input-end bus bar 12 and the third input-end bus bar 13 at connector parts 52a and 52b at one end, and is coupled to the power supply line at another end 52c.

The fourth input-end bus bar 14 and the fifth input-end bus bar 15 are coupled to one another by the third extension bus bar 53. This third extension bus bar 53 is coupled to the connector parts 14a and 15a of the fourth input-end bus bar 14 and the fifth input-end bus bar 15 at connector parts 53a and 53b at one end, and is coupled to the power supply line at another end 53c.

It should be noted that the extension bus bars 51 to 53 are bent to form an L-shape, for example, and are extended to a better position to be worked with by workers.

As illustrated in FIG. 9B, in the electronic device 5-2, when the power is distributed through the three-phase four-wire system, the first input-end bus bar 11 and the second input-end bus bar 12 are coupled by the fourth extension bus bar 54. This fourth extension bus bar 54 is coupled to the connector parts 11a and 12a of the first input-end bus bar 11 and the second input-end bus bar 12 at connector parts 54a and 54b at one end, and is coupled to the power supply line at another end 54c.

The connector parts 13a, 14a, and 15a of the third, fourth, and fifth input-end bus bars 13, 14, and 15 are connected to connector parts 55a, 56a, and 57a at one end of the fifth, sixth, and seventh extension bus bars 55, 56, and 57. The fifth, sixth, and seventh extension bus bars 55, 56, and 57 are coupled to the power supply line at another end 55b, 56b, and 57b.

It should be noted that the extension bus bars 54 to 57 are bent to form an L-shape, for example, and are extended to a better position to be worked with by workers.

According to the above-described fifth embodiment, it is possible to obtain the same advantage as the advantage of the above-described first embodiment. More specifically, it is possible for the embodiment to realize space-saving and to be able to easily respond to the difference in power distribution systems.

In the present embodiment, the extension bus bars 51 to 57 are provided so as to eliminate the need to remove shelving blocking tools such as a screwdriver from reaching the connecting portions of the power supply lines (and the neutral line), and as a result, work efficiency can be further improved.

All examples and conditional language recited herein are intended for pedagogical purposes to aid the reader in understanding the invention and the concepts contribute by the inventor to furthering the art, and are to be construed as being without limitation to such specifically recited examples and conditions, nor does the organization of such examples in the specification relate to a showing of the superiority and inferiority of the invention. Although the embodiments of the present invention have been described in detail, it should be understood that the various changes, substitutions, and alternation could be made hereto without departing from the spirit and scope of the invention.

## Claims

1. An electronic device comprising:
f ive input-end bus bars (11-15) supplied with three-phase alternating-current power; and
three units (P, Q, R) connected to the five input-end bus bars and supplied with single-phase alternating-current power,
wherein the three units include:
a first unit (P) including a first terminal (P1) and a second terminal (P2);
a second unit (Q) including a third terminal (Q1) and a fourth terminal (Q2); and
a third unit (R) including a fifth terminal (R1) and a sixth terminal (R2), and
wherein the five input-end bus bars include:
a first input-end bus bar (11) connected to the first terminal and the third terminal;
a second input-end bus bar (12) connected to the fifth terminal;
a third input-end bus bar (13) connected to the second terminal;
a fourth input-end bus bar (14) connected to the fourth terminal; and
a fifth input-end bus bar (15) connected to the sixth terminal.

2. An electronic device according to claim 1, wherein
the second input-end bus bar and the third input-end bus bar are coupled to each other;
the fourth input-end bus bar and the fifth input-end bus bar are coupled to each other; and
of the five input-end bus bars, the first input-end bus bar, a coupled body of the second input-end bus bar and the third input-end bus bar, and a coupled body of the fourth input-end bus bar and the fifth input-end bus bar are connected to three-phase three-wire power supply lines and the three-phase alternating-current power is supplied.

3. An electronic device according to claim 1, wherein
the first input-end bus bar and the second input-end bus bar are coupled to each other;
of the five input-end bus bars, a coupled body of the first input-end bus bar and the second input-end bus bar, the third input-end bus bar, the fourth input-end bus bar, and the fifth input-end bus bar are connected to three-phase four-wire power supply lines and the three-phase alternating-current power is supplied; and
the coupled body of the first input-end bus bar and the second input-end bus bar is connected to a neutral line (N) of the three-phase four-wire power supply lines.

4. The electronic device according to claim 1, 2 or 3, further comprising:
a first supply-end bus bar (21) connected to the first terminal;
a second supply-end bus bar (22) connected to the second terminal;
a third supply-end bus bar (23) connected to the third terminal;
a fourth supply-end bus bar (24) connected to the fourth terminal;
a fifth supply-end bus bar (25) connected to the fifth terminal, and
a sixth supply-end bus bar (26) connected to the sixth terminal;
wherein the first input-end bus bar is connected to the first terminal and the third terminal through the first supply-end bus bar and the third supply-end bus bar;
the second input-end bus bar is connected to the fifth terminal through the fifth supply-end bus bar;
the third input-end bus bar is connected to the second terminal through the second supply-end bus bar;
the fourth input-end bus bar is connected to the fourth terminal through the fourth supply-end bus bar; and
the fifth input-end bus bar is connected to the sixth terminal through the sixth supply-end bus bar.

5. The electronic device according to claim 1, wherein
a space between the first input-end bus bar and the second input-end bus bar matches a space between the second input-end bus bar and the third input-end bus bar, and
an identical coupling unit can be used for coupling between the first input-end bus bar and the second input-end bus bar and between the second input-end bus bar and the third input-end bus bar.

6. The electronic device according to claim 1, wherein
at least one of a space (S1) between the first input-end bus bar and the second input-end bus bar and a space (S1) between the second input-end bus bar and the third input-end bus bar, a space (S2) between the third input-end bus bar and the fourth input-end bus bar, and a space (S3) between the fourth input-end bus bar and the fifth input-end bus bar are different from one another.

7. The electronic device according to claim 6, wherein
the space between the first input-end bus bar and the second input-end bus bar matches the space between the second input-end bus bar and the third input-end bus bar.

8. The electronic device according to claim 2, wherein
the first input-end bus bar, the coupled body of the second input-end bus bar and the third input-end bus bar, and the coupled body of the fourth input-end bus bar and the fifth input-end bus bar are connected to the three-phase three-wire power supply lines on a same line.

9. The electronic device according to claim 8, wherein
tips of the first input-end bus bar, the third input-end bus bar, the fourth input-end bus bar, and the fifth input-end bus bar are located on a same line (C2), and
the tip (11a) of first input-end bus bar, the tip (13a) of third input-end bus bar, and coupling units for coupling the tip (14a) of the fourth input-end bus bar and the tip (15a) of the fifth input-end bus bar are connected to the three-phase three-wire power supply line on a same line.

10. The electronic device according to claim 8, wherein
an extension unit is coupled to be located between at least one of the first input-end bus bar, the coupled body of the second input-end bus bar and the third input-end bus bar, and the coupled body of the fourth input-end bus bar and the fifth input-end bus bar and the three-phase three-wire power supply lines, thereby connecting the three-phase three-wire power supply lines on a same line.

11. The electronic device according to claim 10, wherein
the extension unit is a coupling unit for coupling the coupled body.

12. The electronic device according to claim 3, wherein
the coupled body of the first input-end bus bar and the second input-end bus bar, the third input-end bus bar, the fourth input-end bus bar, and the fifth input-end bus bar are connected to the three-phase four-wire power supply lines on a same line.

13. The electronic device according to claim 2, wherein
the first input-end bus bar, the coupled body of the second input-end bus bar and the third input-end bus bar, and the coupled body of the fourth input-end bus bar and the fifth input-end bus bar are coupled to extension bus bars (51-53) and are connected to the three-phase three-wire power supply lines through the extension bus bars.

14. The electronic device according to claim 3, wherein
the coupled body of the first input-end bus bar and the second input-end bus bar, the third input-end bus bar, the fourth input-end bus bar, and the fifth input-end bus bar are coupled to extension bus bars (61-64) and are connected to the three-phase four-wire power supply lines through the extension bus bars.

15. The electronic device according to claim 2, wherein
coupling units (34) with an identical shape are used in the coupled body of the second input-end bus bar and the third input-end bus bar and the coupled body of the fourth input-end bus bar and the fifth input-end bus bar.
